Europäisches Patentamt

**European Patent Office**

**Office européen des brevets**

(19)

(11) Numéro de publication : **0 207 853 B1**

# FASCICULE DE BREVET EUROPEEN

(12)

(45) Date de publication du fascicule du brevet :
**23.01.91 Bulletin 91/04**

(51) Int. Cl.$^5$ : **H01L 23/48**, H01L 21/60,
**G06K 19/06**

(21) Numéro de dépôt : **86401403.0**

(22) Date de dépôt : **26.06.86**

(54) **Procédé de montage d'un circuit intégré sur un support, dispositif en résultant et son application à une carte à microcircuits électroniques.**

(30) Priorité : **26.06.85 FR 8509732**

(43) Date de publication de la demande :
**07.01.87 Bulletin 87/02**

(45) Mention de la délivrance du brevet :
**23.01.91 Bulletin 91/04**

(84) Etats contractants désignés :
**BE CH DE FR GB IT LI NL SE**

(56) Documents cités :
**FR-A- 2 337 381**

(56) Documents cités :
**US-A- 3 670 404**
**US-A- 3 719 981**
**US-A- 3 868 724**
**US-A- 4 087 314**

(73) Titulaire : **BULL S.A.**
**121, Avenue de Malakoff**
**F-75116 Paris (FR)**

(72) Inventeur : **Dehaine, Gérard**
**92, rue Gay-Lussac**
**F-92320 Chatillon (FR)**
Inventeur : **Peytavy, Alain**
**6, passage de Toulouse**
**F-78000 Versailles (FR)**

## Description

L'invention se rapporte à un procédé de montage d'un circuit intégré sur un support, au dispositif résultant de la mise en oeuvre du procédé, et à l'application du dispositif à une carte à microcircuits électroniques et, plus particulièrement, à une carte portative dont l'épaisseur satisfait aux normes ISO (International Standard Organisation) des cartes de crédit, soit 0,76 mm ± 10 % .

On appelle carte à microcircuits électroniques, une carte faite ordinairement d'une feuille rectangulaire en matériau plastique, qui incorpore des microcircuits électroniques portés par un support et qui présente extérieurement des contacts pour la connexion des microcircuits électroniques avec un appareil de traitement de cartes. Les microcircuits électroniques peuvent être destinés à des fonctions très diverses, telles que par exemple les opérations bancaires de débit et de crédit, l'allocation d'unités téléphoniques et l'entrée confidentielle dans un milieu protégé. Ils constituent généralement des circuits de traitement et/ou de mémoire plus ou moins complexes selon l'usage auquel ils sont destinés. Dans la pratique, ils sont formés sur au moins une microplaquette de silicium, appelée couramment circuit intégré, puce ou chip. Pour des raisons de commodité, le terme "puce" sera utilisé dans la suite du texte.

Le support de puce contenu dans la carte est ordinairement une très mince feuille en matière plastique comportant les éléments d'interconnexion entre la ou les puces et les contacts de la carte. Dans un cas particulier, le support présente les contacts de la carte sur l'une de ses faces tandis que l'autre face porte la ou les puces et leurs éléments d'interconnexion avec les contacts. L'ensemble constitue un dispositif, appelé par la suite "pastille", incluant tous les éléments fonctionnels de la carte. La fabrication de la carte consiste alors seulement à incorporer la pastille dans le matériau plastique de la carte, de façon que les contacts de la pastille affleurent une face de la carte et que la puce et ses circuits soient protégés sous la pastille par une épaisseur minimale du matériau plastique de la carte. Le montage de la pastille se fait couramment par insertion dans une cavité de la carte, mais peut aussi bien se faire par enrobage dans le matériau plastique de la carte. L'invention concerne la fabrication d'une telle pastille.

Une pastille doit d'abord satisfaire aux conditions normales d'emploi des cartes souples portatives destinées au grand public. Pour ce faire, il faut que la pastille ait une résistance mécanique suffisante pour protéger la puce et ses éléments d'interconnexion à l'encontre des contraintes exercées sur le support lors des manipulations de la carte. Cependant, il faut qu'elle soit suffisamment souple pour épouser les flexions et torsions pouvant être ordinairement exercées sur la carte, sans endommager la puce, ses éléments d'interconnexion avec les contacts, et les soudures entre ces éléments et la puce.

Une pastille doit aussi pouvoir être incorporée dans une carte dont l'épaisseur est aux normes ISO des cartes de crédit, soit 0,76 mm ± 10 %, tout en laissant en-dessous de la pastille une épaisseur suffisante du matériau plastique de la carte pour la protection de la puce et de ses éléments d'interconnexion. En référence aux valeurs nominales, il s'avère qu'en pratique l'épaisseur minimale du matériau plastique de protection est d'environ 0,20 mm, qui ne laisse ainsi à la pastille qu'une épaisseur de 0,56 mm. Dans la pastille, une puce occupe déjà une épaisseur de 0,30 mm, obtenue après rôdage de l'épaisseur d'origine d'une puce normale. Ceci ne laisse plus qu'une épaisseur possible de 0,26 mm pour l'ensemble du support, des contacts et des éléments de connexion des plots de la puce aux contacts respectifs de la pastille. Dans cet ensemble, on a vu précédemment que le support doit avoir une résistance mécanique suffisante qui, en pratique, requiert une épaisseur de l'ordre de 0,1 mm. Enfin, les contacts sont formés généralement à partir d'une feuille de cuivre collée sur le support, puis gravée et recouverte d'une couche d'or et d'au moins une couche intermédiaire de compatibilité, de nickel par exemple.

D'autre part, le procédé de fabrication d'une pastille doit être simple et bon marché pour convenir à une production en grande série de cartes à bas prix. Il est clair en effet qu'un procédé de fabrication en grande série de pastilles pour cartes n'est intéressant techniquement et commercialement que s'il fait intervenir le minimum de constituants et d'étapes. La simplicité est d'autant plus importante, que compte tenu des contraintes imposées sur l'épaisseur d'une pastille, la fabrication en série doit en outre s'accommoder à des marges de tolérance relativement grandes pour chaque élément de la pastille. La simplicité apparaît donc comme un facteur primordial et décisif dans le choix d'un procédé parmi tous les procédés possibles.

Enfin, dans la pratique, il s'avère que pour un grand nombre de services spécifiques différents, les cartes correspondantes requièrent l'emploi de puces de taille relativement grande, par exemple de l'ordre de 4 à 8 mm de côté. En outre, toute carte ne doit comporter qu'un nombre réduit de contacts, par exemple huit pour les cartes de crédit. Ceci limite à ce nombre les plots de la puce correspondante, qui peuvent même lui être inférieurs dans certains cas. Par conséquent, sur une grande puce, les plots peuvent être suffisamment écartés les uns des autres pour être directement connectés aux contacts respectifs de la puce. Cette possibilité simplifierait d'autant les procédés de fabrication et ne laisserait qu'au cas d'une puce très petite la nécessité de relier les plots de la puce aux contacts de la pastille par l'intermédiaire d'éléments de connexion tels que des fils et des conducteurs libres ou solidaires du support.

Les procédés antérieurs de fabrication de pastilles ne satisfont pas à toutes les conditions qui viennent d'être énoncées, surtout si les pastilles sont destinées à des cartes à épaisseur normalisée. La fabrication actuelle est celle conforme au brevet français n° 2 439 478 de la demanderesse. Le procédé consiste à percer des trous dans le support, à coller une feuille de cuivre sur une face du support et à la graver puis la dorer pour former les contacts de la pastille, à métalliser les trous, puis à procéder aux étapes de dépôt et de photogravure d'une couche conductrice sur l'autre face du support pour former des plages de connexion, et à souder sur ces plages de connexion les éléments d'entrée-sortie des circuits intégrés portés par une ou deux puces. En d'autres termes, ce procédé a recours à la technologie des trous métallisés et à une métallisation sur les deux faces du support. Ainsi, en plus de la complexité de ce procédé, la pastille qui en résulte s'avère coûteuse et encombrante.

Une variante actuellement mise en oeuvre consiste à ménager une ouverture dans le support pour coller la puce directement sur une partie de la feuille de cuivre qui bouche cette ouverture. Comme avantages, la pastille correspondante a une faible épaisseur du fait que l'épaisseur du support ne s'ajoute pas à celle de la puce, et la partie de cuivre sous la puce favorise l'évacuation des calories issues des microcircuits et peut servir à la polarisation d'une puce de type N-MOS. Cependant, la liaison directe de la puce avec la mince feuille de cuivre extérieure a l'inconvénient de rendre la puce plus sensible aux forces de pression, de torsion et de flexion susceptibles d'être exercées sur les cartes souples de grand public dans les conditions normales d'emploi. D'autre part, le procédé de fabrication demeure complexe et coûteux, et nécessite en plus la connexion par fils des plots de la puce aux plages de connexion avec les contacts.

Un perfectionnement à ces procédés de fabrication a été présenté dans les brevets francais n° 2 439 322 et 2 439 438 de la demanderesse. Selon ce perfectionnement, les extrémités des pattes de la puce sont fixées directement aux contacts respectifs dans des trous percés dans le support, fermés par les contacts et remplis au moins partiellement de brasure. Cependant, l'adjonction de la brasure dans les trous est une étape délicate du procédé. D'autre part, avant ou pendant le brasage, il faut procéder à une opération aussi délicate de cambrage des pattes. Un procédé analogue est aussi connu de US-A-3868724. Cet art antérieur constitue le préambule de la revendication 1.

Il est à noter que les procédés antérieurs qui viennent d'être présentés ont, en plus de leurs défauts propres, un inconvénient qui leur est commun. En effet, tous ces procédés requièrent la présence d'éléments de connexion entre les plots de la puce et les contacts de la pastille. Ces éléments de connexion sont des fils de liaison, ou les pattes des puces, ou des conducteurs formés à partir d'une couche métallique reposant sur la face intérieure du substrat de la pastille, ou une combinaison de ces éléments. L'emploi de fils de connexion correspond à la technologie dite "wire bonding". L'adjonction de pattes aux puces peut être faite par la technique de montage de puces sur ruban, appelée couramment TAB (Tape Automatic Bonding). Enfin, la formation de conducteurs sur le support peut être faite par collage et gravure d'une feuille de cuivre, ou par dépôt métallique. En d'autres termes, les procédés antérieurs font tous intervenir nécessairement des étapes de procédé coûteuses et parfois délicates.

L'invention satisfait à toutes les conditions énoncées plus haut et offre ainsi l'avantage d'obtenir aisément et à bas prix une pastille mécaniquement résistante, de faible épaisseur, de structure simple et permettant la connexion directe des plots de la puce aux contacts de la pastille.

L'invention concerne d'abord un procédé de montage d'un circuit intégré sur un support tel que revendiqué dans la revendication 1.

En corollaire, un dispositif porteur de circuits intégrés conforme à l'invention comprend les éléments de la revendication 7.

L'invention se rapporte aussi à une carte à microcircuits électroniques, du type incorporant une pastille qui présente sur une face une couche métallique présentant les contacts de la carte et comporte au moins un circuit intégré, caractérisé en ce que la pastille résulte du dispositif tel que décrit précédemment.

Les caractéristiques et avantages de l'invention ressortiront de la description qui suit, faite à titre d'exemple en référence aux dessins annexés.

Dans les dessins :
- la figure 1 est une vue en coupe, suivant la ligne I-I indiquée à la figure 2, d'un mode de réalisation d'une pastille conforme à l'invention, montée dans une carte portative illustrée partiellement ;
- la figure 2 est une vue de dessus de la pastille et de la partie de carte représentées sur la figure 1 ;
- les figures 3A, 3B et 3C sont des vues de détail agrandies au niveau d'un trou de la pastille représentée sur la figure 1, illustrant les trois étapes, respectivement initiale, intermédiaire et finale du procédé de montage d'une puce sur un support conformément à l'invention ;
- la figure 4 est une vue similaire à la figure 3C, illustrant une variante de fabrication d'une pastille conforme à l'invention ;
- la figure 5 est une vue similaire à la figure 3C, illustrant une autre variante de fabrication d'une pastille conforme à l'invention ;

- la figure 6 est une vue en coupe partielle, similaire à celle de la figure 1, illustrant une variante de réalisation d'un dispositif de polarisation de la puce pour une pastille conforme à l'invention ;

- la figure 7 est une vue en perspective d'une variante de réalisation d'un dispositif conforme à l'invention, à partir duquel sont suggérées les diverses étapes de fabrication et d'utilisation de ce dispositif ;

- la figure 8 est une vue en coupe, faite suivant la ligne VIII-VIII indiquée à la figure 9 et similaire à celle de la figure 1, d'une variante de réalisation d'une pastille conforme à l'invention, montée dans une carte portative illustrée partiellement ; et

- la figure 9 est une vue de dessus, similaire à celle de la figure 2, de la pastille et de la partie de carte représentées sur la figure 8.

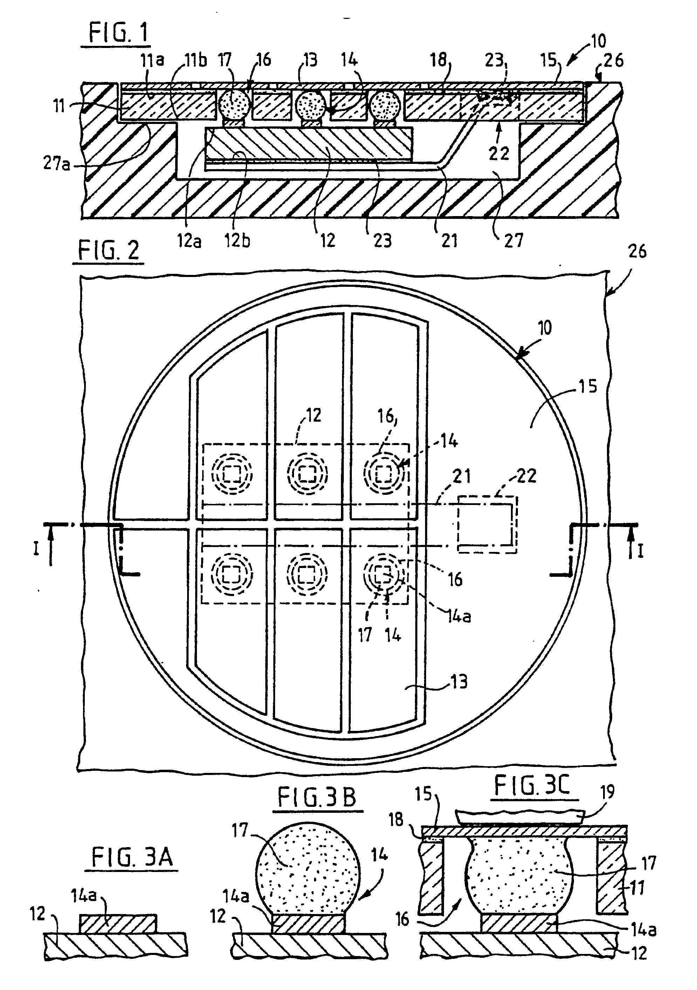

Les figures 1 et 2 illustrent le mode de réalisation préféré d'un dispositif porteur d'un circuit intégré. Ce dispositif se présente sous la forme d'une pastille (10) composée essentiellement d'un support (11), d'une puce (12) et de contacts (13).

Le support (11) est une mince feuille en matériau électriquement isolant, tel que celui connu sous la marque déposée "Kapton". La face (11a) du support (11) est en grande partie recouverte par une couche métallique (15) constituant notamment les contacts (13) de la pastille (10). La couche métallique (15) est généralement formée par une mince feuille de cuivre fixée contre la face (11a) du support (11) par une couche de colle (18), puis dûment gravée et dorée. Des trous (16) sont ménagés dans le support (11) sous des contacts respectifs (13) de la couche métallique (15). Dans la pratique, les trous (16) sont percés dans le support avant la mise en place de la couche métallique (15).

La puce (12) porte sur sa face active (12a) des circuits intégrés connectés à des éléments de connexion (14) de la puce, six dans l'exemple illustré. Comme dans le brevet précité n° 2 439 322, ces six éléments de connexion (14) sont soudés dans les trous (16) à six contacts respectifs (13). Selon l'invention, les six éléments de connexion (14) qui sont soudés aux six contacts respectifs (13) sont les plots respectifs de la puce (12) auxquels on a donné une hauteur approximativement égale à l'épaisseur du support (11). Cette épaisseur est de l'ordre de 0,1 mm pour une pastille destinée à une carte portative à épaisseur normalisée.

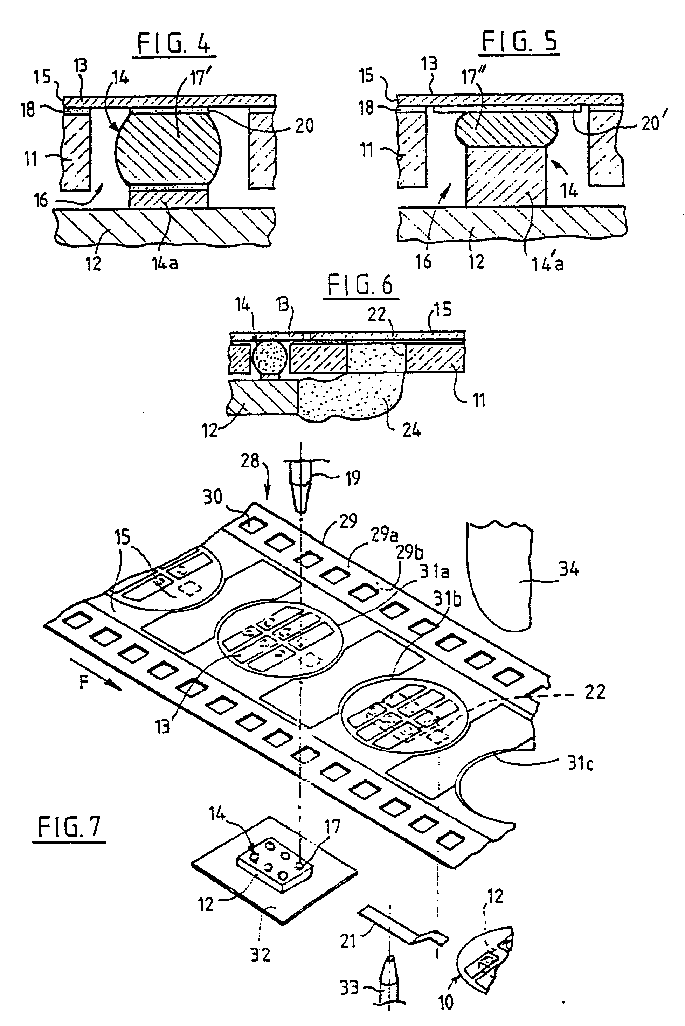

Les figures 3A, 3B, 3C illustrent respectivement les étapes initiale, intermédiaire et finale d'un exemple de procédé de montage conforme à l'invention de la puce (12) sur les contacts (13) du support (11). Comme représenté sur la figure 3A, ce procédé emploie initialement une puce (12) classique, dont les plots (14a) ont une hauteur très faible par rapport à la face active (12a) de la puce (12), de l'ordre de quelques micromètres, 2 um par exemple. La figure 3B illustre l'emploi, sur chaque plot (14a), d'une boule massive (17) de brasure tendre, telle que l'étain-plomb, pour donner à la puce (12) des plots (14) ayant une hauteur approximativement égale à l'épaisseur du support (11). La formation de boules massives en étain-plomb est bien connue dans la technique. On peut par exemple obtenir une boule de l'ordre de 100 um (micromètres) de hauteur en pulvérisant sur le cuivre de chaque plot initial (14a) de la brasure en étain-plomb sur une épaisseur de 20 à 30 um et en chauffant cette brasure. Il suffit alors de disposer les boules (17) des plots (14) de la puce (12) dans les trous correspondants (16) du support (11) et de chauffer les contacts respectifs (13) au moyen d'un outil (19), comme indiqué à la figure 3C, pour obtenir la pastille (10) conforme à l'invention qui a été représentée sur les figures 1 et 2. En pratique, les faces (12a) de la puce et (11b) du support seront en contact ou très proches l'une de l'autre. Pour la clarté des dessins, les figures 3A, 3B et 3C ainsi que les figures 4 et 5 ne respectent pas les proportions des éléments représentés.

La figure 4 est une vue similaire à la figure 3C, illustrant une variante de fabrication d'une pastille (10) conforme à l'invention. Cette variante part d'une puce (12) classique comme celle représentée sur la figure 3A et dispose sur chaque plot (14a) une pièce métallique (17') formant entretoise pour obtenir un plot (14) conforme à l'invention. La pièce métallique (17') représentée sur la figure 4 est une bille de cuivre pourvue de méplats diamétralement opposés pour être soudée au plot (14a) et, ultérieurement au contact (13) respectif. Le soudage de la bille (17') au plot (13) par l'outil (19) utilise une couche de brasure tendre (20) avantageusement déposée sous le contact (13) avant insertion du plot (14).

La figure 5 est aussi une vue similaire à la figure 3C, illustrant une autre variante de fabrication d'une pastille conforme à l'invention. Selon cette variante, chaque plot (14) conforme à l'invention est issu d'un plot initial (14'a) très élevé, surmonté d'une couche d'or (17"). Ainsi un plot (14) de 100 um peut être formé d'un plot initial d'environ 70 um et d'une couche épaisse d'or d'environ 30 um. Le dépôt d'une couche d'or sur un plot métallique de cuivre ou d'aluminium est couramment utilisé dans la technique. Le plot initial (14'a) peut être fait par exemple par dépôt électrolytique. Selon cette variante, le soudage du plot (14) au contact (13) est fait au moyen de l'outil (19) par thermocompression de la couche d'or (17") contre une couche d'or (20') préalablement déposée sous le contact (13).

Bien que les exemples illustrés se rapportent au soudage des plots (14) de la puce (12) aux contacts (13) de la couche métallique (15), il est clair que le soudage est pratiquement indifférent à l'état de la couche métallique (15) et peut donc se faire à tout moment, depuis son état initial jusqu'à son état final qui a servi d'exemple.

Il ressort des figures 1 et 2 que la pastille (10) pourrait normalement se limiter à l'emploi d'un support (11), d'une couche métallique (15) fermant des trous (16) du support, et d'une puce (12) dont les plots (14) sont soudés à la couche métallique (15). Cependant, dans le cas où les circuits intégrés de la puce (12) sont du type N-MOS, il est nécessaire de polariser la base (12b) de la puce. Les exemples illustrés tiennent compte de cette éventualité et proposent différents dispositifs de polarisation. Dans les figures 1 et 2, le dispositif de polarisation représenté est formé d'une lame métallique conductrice (21) reliant la base (12b) de la puce (12) à l'un des contacts (13) de la couche métallique (15) à travers un trou (22) du support (11). La liaison illustrée de la lame (21) à la puce (12) et au contact (13) est faite par des couches respectives (23) de colle conductrice, par exemple de l'époxy chargé en argent. Eventuellement, la lame (21) pourrait simplement servir de drain thermique. Une variante de réalisation telle qu'illustrée dans la figure 6 consiste à remplacer la lame (21) par une masse de colle conductrice (24) qui remplit le trou (22) et se prolonge jusqu'à une paroi de la puce (12).

Les figures 1 et 2 illustrent également l'application de la pastille (10) à la réalisation d'une carte portative (26). L'exemple de réalisation représenté correspond à celui décrit dans le brevet francais précité n° 2 337 381. Selon ce brevet, la carte est une simple feuille faite en un matériau plastique et pourvue d'une cavité (27) conformée pour contenir et fixer la pastille (10) de façon que les contacts (13) soient sensiblement coplanaires avec la face correspondante de la carte (26). La fixation est généralement faite par collage (non représenté) de la périphérie du support (11) sur un épaulement correspondant (27a) de la cavité (27). Cependant, on comprend que l'invention ne se limite pas à ce mode de réalisation et que la pastille (10) peut par exemple être simplement noyée dans le matériau plastique de la carte.

La figure 7 illustre une variante de réalisation d'un dispositif porteur de puces à circuits intégrés conforme à l'invention. Selon cette variante, le dispositif (28) a un support (29) se présentant sous la forme d'un film plastique de type cinématographique à double rangée de perforations (30) régulièrement espacée le long des bords du film. Le support (29) est partagé en une série de domaines adjacents (31a, 31b, 31c, 31d, ...) destinés à reproduire chacun la même structure que celle de la pastille (10) représentée sur les figures 1 et 2. La figure 5 attribue donc les mêmes chiffres de référence aux composants analogues à ceux de la pastille (10). Ainsi, le support (29) de chaque domaine (31) est percé de six trous (16) et d'un trou additionnel (22). Un ruban de cuivre (15) a été collé sur une face du support (29), puis gravé et doré pour former les contacts (13) recouvrant les trous de chaque domaine (31) illustré.

A partir de cet état initial des domaines (31) du film (29), la figure 7 illustre schématiquement les étapes du procédé conforme à l'invention pour l'élaboration de pastilles (10) telle que celle représentée sur les figures 1 et 2. Il est supposé qu'à chaque domaine successif est opérée une phase différente du procédé tel que décrit en référence aux figures 3A, 3B, lorsque le film se déroule dans le sens de la flèche (F). Le domaine (31a) vient se positionner par rapport à une puce (12) portée par une table (32). Au-dessus des contacts (13), l'outil (19) effectue le soudage de ces contacts aux plots (14) de la puce (12). Il est résulte la configuration représentée dans le domaine (31b) du dispositif (28). Au niveau de ce domaine, un dispositif d'application de colle (33), tel qu'une seringue ou un tampon, dépose des couches de colle (23) sous la puce (12) et dans le trou (22). La mise en place de la lame (21) aboutit, dans le domaine (31c) à la configuration de la pastille (10) représentée sur les figures 1 et 2 et illustrée de façon fragmentaire sur la figure 7 après l'action d'une matrice de découpage (34) pour prélever la pastille (10) du dispositif (28).

Bien entendu, l'outil (19) n'est donné qu'à titre d'exemple. D'une manière générale, tout moyen de chauffage peut être utilisé pour le soudage individuel ou collectif des plots (14). Ainsi, un four pourrait être utilisé pour un soudage collectif éventuellement pour le traitement de la colle.

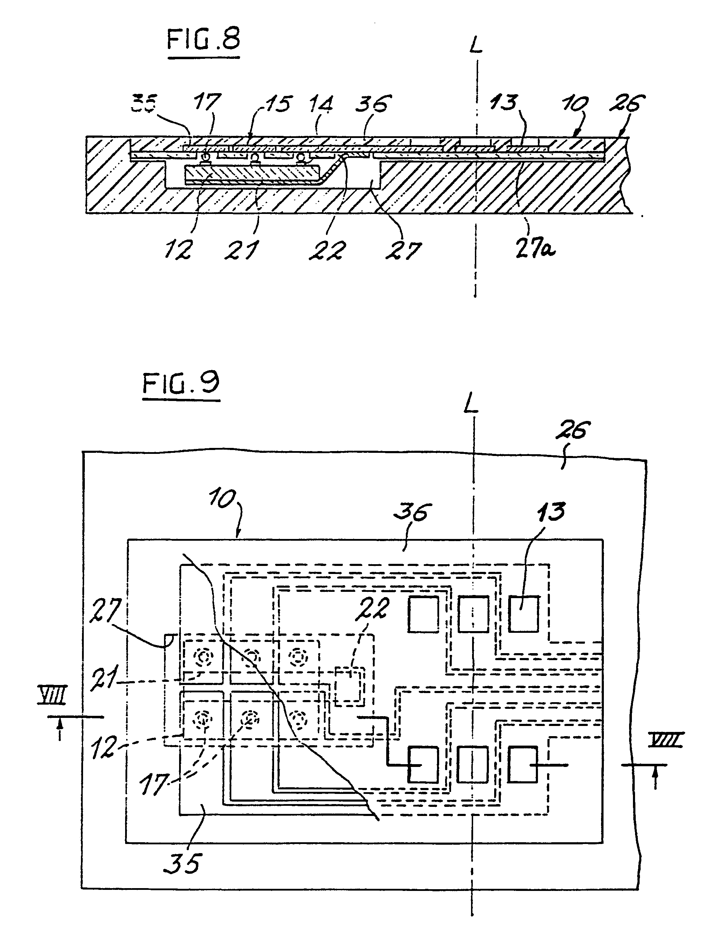

Les figures 8 et 9 sont des vues respectivement analogues à celles des figures 1 et 2 d'une variante de réalisation d'une pastille (10) conforme à l'invention. Les mêmes chiffres de référence désignent les mêmes éléments. Selon la variante des figures 8 et 9, les contacts (13) sont dans une zone située en dehors de la cavité (27) incorporant la puce (12). La pastille (10) correspondante est de ce fait appelée pastille à contacts décalés. Dans l'exemple illustré, la pastille (10) est placée dans la carte de manière que les contacts (13) soient disposés au voisinage de la ligne médiane (L) parallèle à la longueur de la carte et que la puce demeure logée dans un coin de la carte. Ainsi, les contraintes exercées sur la puce par la flexion et la torsion de la carte sont réduites par rapport à celles que subirait une puce placée au niveau des contacts (13) comme dans le cas des figures 1 et 2. Selon la variante des figures 8 et 9, la couche métallique (15) se compose de six bandes (35) présentant chacune à une extrémité un bossage (17) et, à l'autre extrémité, un contact correspondant (13). Les contacts (13) sont délimités par des trous respectifs ménagés dans un film de matière plastique isolante (36) recouvrant toute la pastille (10). Eventuellement, les trous peuvent être remplis de matière conductrice. Dans l'exemple illustré, la bande centrale (35) est en outre reliée à la lame (21) par l'intermédiaire du trou (22). Autrement, une bande (35) supplémentaire pourrait évidemment être attribuée à la liaison de la lame (21) à un contact respectif (13). Il est aussi évident que tous les modes de réalisation illustrés dans les figures 1 à 9 peuvent s'adapter les uns aux autres.

## Revendications

1. Procédé pour monter un circuit intégré (12) sur une face d'un support (11), et pour connecter électriquement, au travers de trous (16) réalisés dans l'épaisseur du support, les plots du circuit intégré (12) à des contacts (13) appliqués sur l'autre face du support, caractérisé en ce qu'il consiste à percer les trous (16) dans le support (11), à fermer les trous (16) par une couche métallique (15) constituant les contacts (13), et en ce qu'il consiste à souder directement chaque plot (14) du circuit intégré à chaque contact (13) respectif du support, en faisant passer chaque plot dans le trou associé au contact respectif, et en ce que, à cet effet, l'ensemble des plots est disposé sur la même face du circuit intégré, et en ce que la hauteur de chaque plot est approximativement égale, sans y être inférieure, à l'épaisseur du support, de façon que les plots constituent les éléments de connexion électriques entre le circuit intégré et les contacts (13).

2. Procédé selon la revendication 1, caractérisé en ce qu'il consiste à former une boule massive (17) de brasure tendre sur chaque plot initial (14a) d'un circuit intégré classique (12).

3. Procédé selon la revendication 1, caractérisé en ce qu'il consiste à disposer sur chaque plot initial (14a) d'un circuit intégré classique un élément conducteur formant entretoise (17').

4. Procédé selon la revendication 1, caractérisé en ce qu'il consiste à surélever les plots initiaux (14a), par dépôt électrolytique par exemple.

5. Procédé selon la revendication 4, caractérisé en ce qu'il consiste à disposer une couche d'or (17") sur les plots initiaux surélevés (14'a).

6. Procédé selon l'une des revendications 1 à 5, caractérisé en ce qu'il consiste à relier électriquement une paroi du circuit intégré (12) à la couche métallique (15) à travers un trou (22) traversant le support (11) sous la couche (15).

7. Dispositif (10, 28) porteur de circuits intégrés (12), comprenant un support (11, 29) percé de trous (16) et ayant une face (11a, 29a) pourvue d'une couche métallique (15) fermant les trous (16) et une autre face (11b, 29b) pourvue d'au moins un circuit intégré (12) ayant ses éléments de connexion (14) soudés dans les trous à ladite couche métallique, caractérisé en ce que les éléments de connexion sont les plots respectifs (14) du circuit intégré (12), ayant une hauteur approximativement égale, sans y être inférieure, à l'épaisseur du support (11, 29).

8. Dispositif selon la revendication 7, caractérisé en ce que chaque plot (14) se compose d'un plot initial (14a) surmonté d'une boule massive (17) de brasure tendre.

9. Dispositif selon la revendication 7, caractérisé en ce que chaque plot (14) se compose d'un plot initial (14a) surmonté d'un élément conducteur formant entretoise (17').

10. Dispositif selon la revendication 7, caractérisé en ce que chaque plot est un plot initial surélevé (14'a).

11. Dispositif selon la revendication 10, caractérisé en ce que chaque plot initial surélevé est surmonté d'une couche épaisse d'or (17").

12. Dispositif selon l'une des revendications 7 à 11, caractérisé en ce qu'il comporte un dispositif de polarisation (21, 24) entre une paroi du circuit intégré et la couche métallique à travers un trou (22) traversant le support sous la couche métallique.

13. Dispositif selon la revendication 12, caractérisé en ce que le dispositif de polarisation est une lame métallique conductrice (21) fixée au dos (12b) de la puce (12).

14. Dispositif selon la revendication 12, caractérisé en ce que le dispositif de polarisation est formé par de la colle conductrice (24).

15. Dispositif selon l'une des revendications 7 à 14, caractérisé en ce que le support (29) est un film du type cinématographique présentant des domaines adjacents (31a, 31b, ...) identiques, pourvus d'une couche métallique (15) fermant des trous respectifs (16) du support (29) et soudée dans ces trous aux plots (14, 25) d'au moins un circuit intégré (12), les plots étant pourvus d'une hauteur sensiblement égale à l'épaisseur du support.

16. Dispositif selon l'une des revendications 7 à 15, caractérisé en ce que la couche métallique (15) qui ferme les trous (16) constitue des contacts respectifs (13) du dispositif.

17. Dispositif selon l'une des revendications 7 à 15, caractérisé en ce que la couche métallique (15) se compose de bandes (35) présentant chacune à une extrémité un bossage (17) et à une autre extrémité un contact (13).

18. Dispositif selon la revendication 16 ou 17, caractérisé en ce qu'il est recouvert d'un film isolant (36) pourvu de trous délimitant les contacts (13).

19. Carte (26) à microcircuits électroniques, du type incorporant une pastille (10) qui présente sur une face une couche métallique présentant les contacts (13) de la carte et qui comporte au moins un circuit intégré (12), caractérisée en ce que la pastille (10) résulte du dispositif tel que décrit dans l'une des revendications 7 à 18.

20. Carte selon la revendication 19, caractérisée en ce que le circuit intégré (12) est placé dans un coin de la carte tandis que les contacts (13) sont situés dans une zone médiane de la carte.

**Ansprüche**

1. Verfahren zur Montage einer integrierten Schaltung (12) auf einer Fläche eines Trägers (11) sowie zum elektrischen Anschließen von Klötzchen der integrierten Schaltung (12) an Kontakten (13), die auf der anderen Fläche des Trägers angebracht sind, über Löcher (16), die in der Dicke des Trägers vorgesehen sind, dadurch gekennzeichnet, daß es darin besteht, die Löcher (16) in dem Träger (11) durchzubohren, die Löcher (16) durch eine die Kontakte (13) bildende metallischen Schicht (15) zu schließen und jedes Klötzchen (14) der integrierten Schaltung direkt an jeden jeweiligen Kontakt (13) des Trägers anzulöten, indem jedes Klötzchen in das dem jeweiligen Kontakt zugeordnete Loch gebracht wird, und daß zu diesem Zweck die Gesamtheit der Klötzchen auf derselben Fläche der integrierten Schaltung angeordnet wird und die Höhe jedes Klötzchens der Dicke des Trägers annähernd entspricht, ohne dabei kleiner als diese zu sein, so daß die Klötzchen die elektrischen Verbindungselemente zwischen der integrierten Schaltung und den Kontakten (13) bilden.

2. Verfahren nach Anspruch 1, dadurch gekennzeichnet, daß es darin besteht, eine massive Kugel (17) aus Weichlot auf jedem Anfangsklötzchen (14a) einer herkömmlichen integrierten Schaltung (12) zu bilden.

3. Verfahren nach Anspruch 1, dadurch gekennzeichnet, daß es darin besteht, auf jedem Anfangsklötzchen (14a) einer herkömmlichen integrierten Schaltung ein eine Strebe bildendes Leiterelement (17') anzuordnen.

4. Verfahren nach Anspruch 1, dadurch gekennzeichnet, daß es darin besteht, die Anfangsklötzchen (14a) z.B. durch elektrolytischen Überzug zu erhöhen.

5. Verfahren nach Anspruch 4, dadurch gekennzeichnet, daß es darin besteht, eine Goldschicht (17") auf die erhöhten Anfangsklötzchen (14'a) aufzubringen.

6. Verfahren nach einem der Ansprüche 1 bis 5, dadurch gekennzeichnet, daß es darin besteht, eine Wand der integrierten Schaltung (12) mit der metallischen Schicht (15) über ein Loch (22), das den Träger (11) unter der Schicht (15) durchquert, elektrisch zu verbinden.

7. Trägervorrichtung (10, 28) für integrierte Schaltungen (12), mit einem mit Löchern (16) versehenen Träger (11, 29), der eine Fläche (11a, 29a), die mit einer die Löcher (16) verschließenden metallischen Schicht (15) versehen ist sowie eine weitere Fläche (11b, 29b) aufweist, die mit wenigstens einer integrierten Schaltung (12) versehen ist, wovon die Verbindungselemente (14) in den Löchern an die genannte metallische Schicht angelötet sind, dadurch gekennzeichnet, daß die Verbindungselemente die jeweiligen Klötzchen (14) der integrierten Schaltung (12) sind, die eine annähernd gleiche Höhe wie die Dicke des Trägers (11, 29) aufweisen, ohne geringer als diese zu sein.

8. Vorrichtung nach Anspruch 7, dadurch gekennzeichnet, daß jedes Klötzchen (14) aus einem Anfangsklötzchen (14a), das von einer massiven Kugel (17) aus Weichlot überragt wird, besteht.

9. Vorrichtung nach Anspruch 7, dadurch gekennzeichnet, daß jedes Klötzchen (14) aus einem Anfangsklötzchen (14a), das von einem eine Strebe bildenden Leiterelement (17') überragt wird, besteht.

10. Vorrichtung nach Anspruch 7, dadurch gekennzeichnet, daß jedes Klötzchen ein erhöhtes Anfangsklötzchen (14'a) ist.

11. Vorrichtung nach Anspruch 10, dadurch gekennzeichnet, daß jedes erhöhte Klötzchen von einer dicken Goldschicht (17") überragt wird.

12. Vorrichtung nach einem der Ansprüche 7 bis 11, dadurch gekennzeichnet, daß sie eine Polarisationsvorrichtung (21, 24) zwischen einer Wand der integrierten Schaltung und der metallischen Schicht über ein Loch (22), das den Träger unter der metallischen Schicht durchquert, umfaßt.

13. Vorrichtung nach Anspruch 12, dadurch gekennzeichnet, daß die Polarisationsvorrichtung eine metallische Lamelle (21) ist, die auf der Rückseite (12b) des Bauteils (12) befestigt ist.

14. Vorrichtung nach Anspruch 12, dadurch gekennzeichnet, daß die Polarisationsvorrichtung aus einem leitenden Klebstoff (24) gebildet ist.

15. Vorrichtung nach einem der Ansprüche 7 bis 14, dadurch gekennzeichnet, daß der Träger (29) ein Film vom Typ eines Kino-Films ist, der identische, nebeneinanderliegende Bereiche (31a, 31b,...) aufweist, die mit einer metallischen Schicht (15) versehen sind, welche jeweilige Löcher (16) des Trägers (29) schließt und in diesen Löchern an die Klötzchen (14, 25) wenigstens einer integrierten Schaltung (12) angelötet sind, wobei die Klötzchen eine Höhe, die der Dicke des Trägers im wesentlichen entspricht, aufweisen.

16. Vorrichtung nach einem der Ansprüche 7 bis 15, dadurch gekennzeichnet, daß die die Löcher (16) verschließende metallische Schicht (15) die jeweiligen Kontakte (13) der Vorrichtung bildet.

17. Vorrichtung nach einem der Ansprüche 7 bis 15, dadurch gekennzeichnet, daß die metallische Schicht (15) aus Bändern (35) besteht, wovon jedes einen Höcker (17) an einem Ende sowie einen Kontakt (13) an einem anderen Ende aufweist.

18. Vorrichtung nach Anspruch 16 oder 17, dadurch gekennzeichnet, daß sie mit einem isolierenden Film (36), der mit die Kontakte (13) abgrenzenden Löchern versehen ist, überzogen ist.

19. Karte (26) mit elektronischen Mikroschaltungen vom Typ mit einem Plättchen (10), das auf einer Fläche eine die Kontakte (13) der Karte aufweisende metallische Schicht und wenigstens eine integrierte Schaltung (12) aufweist, dadurch gekennzeichnet, daß das plättchen (10) aus der Vorrichtung, wie sie in einem der Ansprüche 7 bis 18 beschrieben ist, hervorgeht.

20. Karte nach Anspruch 19, dadurch gekennzeichnet, daß die integrierte Schaltung (12) in einer Ecke der Karte angeordnet ist, während die Kontakte (13) in einem Mittelbereich der Karte gelegen sind.

## Claims

1. Method for mounting an integrated circuit (12) on one face of a support (11), and for electrically connecting, through holes (16) made in the thickness of the support, the contact studs of the integrated circuit (12) to contacts (13) applied to the other face of the support, characterized in that it consists of making the holes (16) in the support (11), closing the holes (16) by a metallic layer (15) constituting the contacts (13), and in that it consists of directly soldering each contact stud (14) of the integrated circuit to each respective contact (13) of the support, by engaging each contact stud in the hole associated with the respective contact, and in that, to accomplish this, all the contact studs are arranged on the same face of the integrated circuit, and in that the height of each contact stud is approximately equal to, and not less than, the thickness of the support, so that the contact studs constitute the electrical connecting elements between the integrated circuit and the contacts (13).

2. Method according to Claim 1, characterized in that it consists of forming a solid ball (17) of soft solder on each initial contact stud (14a) of a conventional integrated circuit (12).

3. Method according to Claim 1, characterized in that it consists of arranging on each initial contact stud (14a) of a conventional integrated circuit a conductive element forming a spacer (17').

4. Method according to Claim 1, characterized in that it consists of increasing the height of the initial contact studs (14a), for example by electrolytic deposit.

5. Method according to Claim 4, characterized in that it consists of placing a layer of gold (17") on the heightened initial contact studs (14'a).

6. Method according to one of Claims 1 to 5, characterized in that it consists of electrically connecting a wall of the integrated circuit (12) to the metallic layer (15) via a hole (22) through the support (11) under the layer (15).

7. Device (10, 28) carrying integrated circuits (12), comprising a support (11, 29) pierced with holes (16) and having a face (11a, 29a) provided with a metallic layer (15) closing the holes (16) and another face (11b, 29b) provided with at least one integrated circuit (12) having its connecting elements (14) soldered in the holes to the said metallic layer, characterized in that the connecting elements are the respective contact studs (14) of the integrated circuit (12), having a height approximately equal to, and not less than, the thickness of the support (11, 29).

8. Device according to Claim 7, characterized in that each contact stud (14) is made up of an initial contact stud (14a) surmounted by a solid ball (17) of soft solder.

9. Device according to Claim 7, characterized in that each contact stud (14) is made up of an initial contact stud (14a) surmounted by a conductive element forming a spacer (17').

10. Device according to Claim 7, characterized in that each contact stud is a heightened initial contact (14'a).

11. Device according to Claim 10, characterized in that each heightened initial contact stud is surmounted by a thick layer of gold (17").

12. Device according to one of Claims 7 to 11, characterized in that it has a polarization device (21, 24) between one wall of the integrated circuit and the metallic layer via a hole (22) through the support under the metallic layer.

13. Device according to Claim 12, characterized in that the polarization device is a conductive metal strip (21) fixed to the back (12b) of the chip (12).

14. Device according to Claim 12, characterized in that the polarization device is formed by conductive adhesive (24).

15. Device according to one of Claims 7 to 14, characterized in that the support (29) is a film of the cinematographic type having identical adjacent regions (31a, 31b, etc.), provided with a metallic layer (15) closing respective holes (16) in the support (29) and soldered in these holes to the contact studs (14, 25) of at least one integrated circuit (12), the contact studs having a height substantially equal to the thickness of the support.

16. Device according to one of Claims 7 to 15, characterized in that the metallic layer (15) closing the holes (16) constitutes respective contacts (13) of the device.

17. Device according to one of Claims 7 to 15, characterized in that the metallic layer (15) is composed of bands (35) each having a boss (17) at one end and a contact (13) at another end.

18. Device according to Claim 16 or 17, characterized in that it is coated with an insulating film (35) provided with holes bounding the contacts (13).

19. Card (26) with electronic microcircuits, of the type incorporating a wafer (10) which carries on one face a metallic layer presenting the contacts (13) of the card and which comprises at least one integrated circuit (12), characterized in that the wafer (10) results from the device as described in one of Claims 7 to 18.

20. Card according to Claim 19, characterized in that the integrated circuit (12) is located in a corner of the card while the contacts (13) are located in a central region of the card.

FIG. 1

FIG. 2

FIG. 3A

FIG. 3B

FIG. 3C

## FIG. 4

## FIG. 5

## FIG. 6

## FIG. 7

FIG.8

FIG.9